(19) Europäisches Patentamt / European Patent Office / Office européen des brevets

(11) **EP 3 736 977 B1**

(12) **EUROPEAN PATENT SPECIFICATION**

(45) Date of publication and mention
of the grant of the patent:
**21.12.2022 Bulletin 2022/51**

(21) Application number: **19736021.7**

(22) Date of filing: **07.01.2019**

(51) International Patent Classification (IPC):
*H03F 1/02* *(2006.01)*   *H03F 1/32* *(2006.01)*
*H03F 1/18* *(2006.01)*   *H03F 3/189* *(2006.01)*
*H03F 3/20* *(2006.01)*

(52) Cooperative Patent Classification (CPC):
**H03F 1/18; H03F 1/02; H03F 1/32; H03F 3/189;**
**H03F 3/20;** H03F 2200/387; H03F 2200/423;
H03F 2200/451; H03F 2201/3215

(86) International application number:
**PCT/CN2019/070703**

(87) International publication number:
**WO 2019/134702 (11.07.2019 Gazette 2019/28)**

(54) **OUTPHASING POWER AMPLIFIER AND METHOD AND DEVICE FOR ACHIEVING OUTPUT MATCHING THEREOF**

PHASENVERSCHOBENER LEISTUNGSVERSTÄRKER UND VERFAHREN UND VORRICHTUNG ZUR REALISIERUNG EINER AUSGANGSANPASSUNG DAFÜR

AMPLIFICATEUR DE PUISSANCE HORS PHASE AINSI QUE PROCÉDÉ ET DISPOSITIF POUR RÉALISER UNE ADAPTATION DE SORTIE POUR CELUI-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.01.2018 CN 201810011482**

(43) Date of publication of application:
**11.11.2020 Bulletin 2020/46**

(73) Proprietor: **ZTE Corporation**
**Shenzhen, Guangdong 518057 (CN)**

(72) Inventors:
• **YU, Minde**
  **Shenzhen, Guangdong 518057 (CN)**
• **QIN, Tianyin**
  **Shenzhen, Guangdong 518057 (CN)**
• **PENG, Ruimin**
  **Shenzhen, Guangdong 518057 (CN)**
• **ZHANG, Xiaoyi**
  **Shenzhen, Guangdong 518057 (CN)**

(74) Representative: **Aipex B.V.**
**P.O. Box 30223**
**3001 DE Rotterdam (NL)**

(56) References cited:
EP-A1- 2 838 195        CN-A- 104 716 913
CN-A- 106 257 827       CN-A- 106 374 863
CN-A- 107 332 519       CN-A- 108 336 975

• CALVILLO-CORTES DAVID A ET AL: "A Package-Integrated Chireix Outphasing RF Switch-Mode High-Power Amplifier", IEEE TRANSACTIONS ON MICROWAVE THEORY AND TECHNIQUES, PLENUM, USA, vol. 61, no. 10, 1 October 2013 (2013-10-01), pages 3721-3732, XP011528677, ISSN: 0018-9480, DOI: 10.1109/TMTT.2013.2279372 [retrieved on 2013-10-03]
• OZEN MUSTAFA ET AL: "A Generalized Combiner Synthesis Technique for Class-E Outphasing Transmitters", IEEE TRANSACTIONS ON CIRCUITS AND SYSTEMS I: REGULAR PAPERS, IEEE, US, vol. 64, no. 5, 1 May 2017 (2017-05-01), pages 1126-1139, XP011647156, ISSN: 1549-8328, DOI: 10.1109/TCSI.2016.2636155 [retrieved on 2017-04-21]

- **BARTON TAYLOR: "Not Just a Phase: Outphasing Power Amplifiers", IEEE MICROWAVE MAGAZINE, IEEESERVICE CENTER, PISCATAWAY, NJ, US, vol. 17, no. 2, 1 February 2016 (2016-02-01), pages 18-31, XP011591940, ISSN: 1527-3342, DOI: 10.1109/MMM.2015.2498078 [retrieved on 2016-01-12]**

**Description**

TECHNICAL FIELD

The present invention relates to an outphasing power amplifier and a method for achieving output matching of the outphasing power amplifier.

BACKGROUND

Currently, with the increasingly fierce competition in the wireless communication market, the performance of base station products has become the main focus of competition in the industry. As an important constituent part of the base station, a power amplifier (PA) is directly related to the quality of a signal transmitted by the base station and the communication effect. However, in order to achieve higher data transmission rate within a limited bandwidth, modern wireless communication systems all use complex digital modulation techniques. The complex modulation techniques coupled with multicarrier configuration result in improvement of a signal peak-to-average ratio (PAR). The improvement of PAR not only increases the difficulty of a linear index, but also makes it difficult to achieve a goal of high efficiency. This poses a great challenge to a current power amplifier design, that is to say, the power amplifier is required to overcome an increased linearity and achieve high back-off efficiency simultaneously.

In order to ensure that a transmitter has both high efficiency and high linearity, a relevant transmitter structure needs to be improved, such that high-efficiency switching power amplifiers may be applied, and linearization technology is used to ensure the linearity of a system. A technical literature CALVILLO-CORTES DAVID ET AL: "A Package-Integrated Chireix Outphasing RF Switch-Mode High-Power Amplifier", IEEE TRANSACTIONS ON MICROWAVE THEORY AND TECHNIQUES, PLENUM, USA, vol. 61, no. 10, 1 October 2013 (2013-10-01), pages 3721-3732, XP011528677, describes the design and implementation of a package-integrated Chireix outphasing power amplifier . A technical literature OZEN MUSTAFA ET AL: "A Generalized Combiner Synthesis Technique for Class-E Outphasing Transmitters", IEEE TRANSACTIONS ON CIRCUITS AND SYSTEM I: REGULAR PAPERS, IEEE, US, vol. 64, no. 5, 1 May 2017 (2017-05-01), pages 1126-1139, XP011647156, describes a combiner design technique that has been developed for class-E outphasing transmitters.

A technical literature BARTON TAYLOR ET AL: "Not Just a Phase: Outphasing Power Amplifiers", IEEE MICROWAVE MAGAZINE, IEEESERVICE CENTER, PISCATAWAY, NJ, US, vol. 17, no. 2, 1 February 2016 (2016-02-01), pages 18-31, XP011591940, describes the outphasing concept for power amplifiers.

Document EP2838195A1 discloses a combiner circuit for a class-e outphasing power amplifier.

SUMMARY

The present application provides an outphasing power amplifier and a method and device for achieving output matching thereof and a power amplifier branch, which can reduce design complexity.

The scope of the invention is defined by the appended claims.

BRIEF DESCRIPTION OF DRAWINGS

The drawings are used to provide a further understanding of the technical solution of present application and form a part of the specification. The drawings and embodiments of the present application are used to explain the technical solution of the present application and not to limit the technical solution of the present application.

FIG. 1 is a schematic diagram showing composition of an outphasing transmitter system in the related art;
FIG. 2 is a schematic diagram showing composition of a switching mode power amplifier outphasing power amplifier in the related art;
FIG. 3 is a schematic diagram showing composition of an outphasing power amplifier according to an embodiment of the present application;
FIG. 4 is a flowchart of a method for achieving output matching of an outphasing power amplifier according to an embodiment of the present application;
FIG. 5A is a schematic diagram illustrating a variation curve of susceptance B at an input port of a combiner with an outphasing angle when a compensation angle is 23° according to an embodiment of the present application;
FIG. 5B is a schematic diagram illustrating a variation curve of conductance G at an input port of a combined with an outphasing angle when a compensation angle is 23° according to an embodiment of the present application;
FIG. 6 is a schematic diagram of determining an impedance point of a power tube in a load pull mode according to an embodiment of the present application;

FIG. 7 is a schematic diagram in which an output matching circuit achieves matching according to an embodiment of the present application;

FIG. 9 is a schematic diagram showing composition of a multipath outphasing power amplifier according to an embodiment that is not comprised in the claimed invention; and

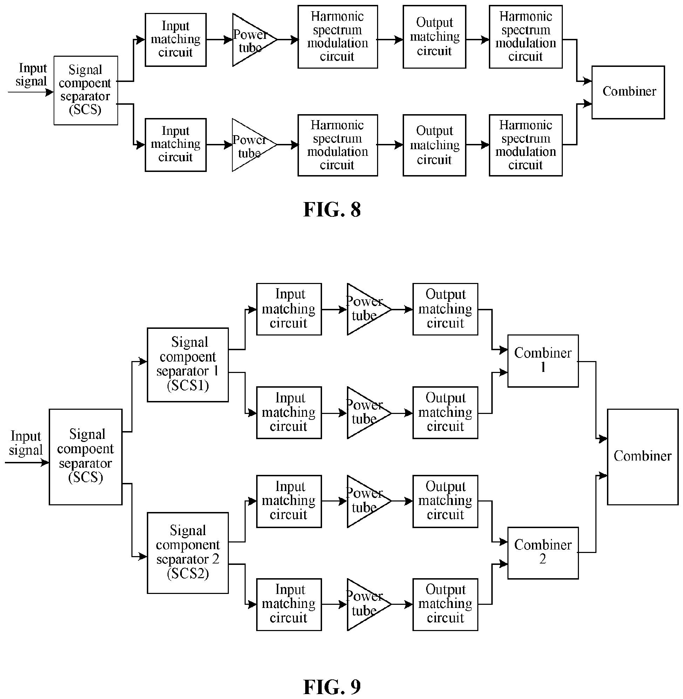

FIG. 8 is a schematic diagram showing composition of an outphasing power amplifier of another embodiment according to the present application.

DETAILED DESCRIPTION

Embodiments of the present application will be described hereinafter in detail in conjunction with the drawings. It is to be noted that if not in collision, the embodiments and features therein in the present application may be combined with each other.

A new high-efficiency transmitter structure includes an outphasing technology, an envelope elimination and restoration (EER) technology, an envelope tracking (ET) technology, a load modulation technology, a pulse width modulation (PWM) technology and the like. The outphasing technology can make a high-efficiency switching mode power amplifier be applied without affecting linearity of a transmitter by separating signals. Therefore, the outphasing technology has become one of the research focuses of high-efficiency power amplifiers and linearization technologies.

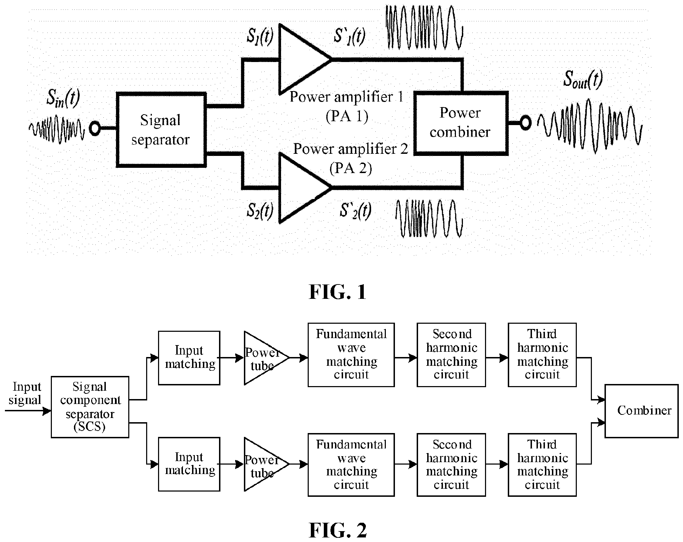

In the related art, an outphasing system mostly adopts two paths or more paths power amplifiers, and the two paths outphasing amplifier has become a mainstream of current applications due to their relatively simple circuit design. FIG. 1 is a schematic diagram showing composition of an outphasing transmitter system in the related art. As shown in FIG. 1, the outphasing transmitter system mainly includes three parts of a signal component separator (SCS), a high-efficiency power amplifier (PA) and a power combiner. The SCS separates an amplitude modulation/phase modulation signal into two outphasing constant envelope signals. The two outphasing constant envelope signals are amplified by two high-efficiency outphasing amplifiers and then restored to an amplitude amplified amplitude modulation/phase modulation signal by the power combiner. Generally, the power combiner needs to use a Cherie non-isolated combiner, in this way, when an outphasing angle of the input signal changes, loads of the two outphasing amplifiers will pull each other, such that the loads of the power amplifiers reach a maximum power point and a maximum efficiency point respectively with the change of the outphasing angle to achieve a purpose of improving output power and efficiency

From the above-mentioned principle, it could be concluded that in order to achieve a high working efficiency of the system, a design of the outphasing power amplifier must be able to ensure that a power amplifier load can still maintain the high working efficiency when changing within a certain range. Therefore, a key step to improve the efficiency of the outphasing technology is to select a high-efficiency power amplifier whose efficiency is not sensitive to load changes. For example, class-E and class-F switching mode power amplifiers (SMPA) have been widely used in an outphasing system. FIG. 2 is a schematic diagram showing composition of a switching mode power amplifier outphasing power amplifier in the related art. As shown in FIG. 2, the SMPA outphasing power amplifier mainly includes an input matching circuit, a power tube, an power amplifier output and harmonic control circuit.

Although both the class-E SMPA and the class-F SMPA used in an outphasing system can obtain higher efficiency and a certain bandwidth, due to inherent characteristics of the switching mode power amplifiers, it is inevitable to deal with a harmonics amplitude of a second, third or even higher and phase of a fundamental wave, and this control of harmonics will increase corresponding circuits. Therefore, the outphasing system has disadvantages of complicated circuit design, large printed circuit board (PCB) occupation area, difficult debugging and the like. If is achieved by a class-E power amplifier quasi-load insensitive technology, a more in-depth understanding of power tube packaging parameters is further needed, and power tube manufacturers may not be willing to provide the parameters, thus further limiting the application of this technology.

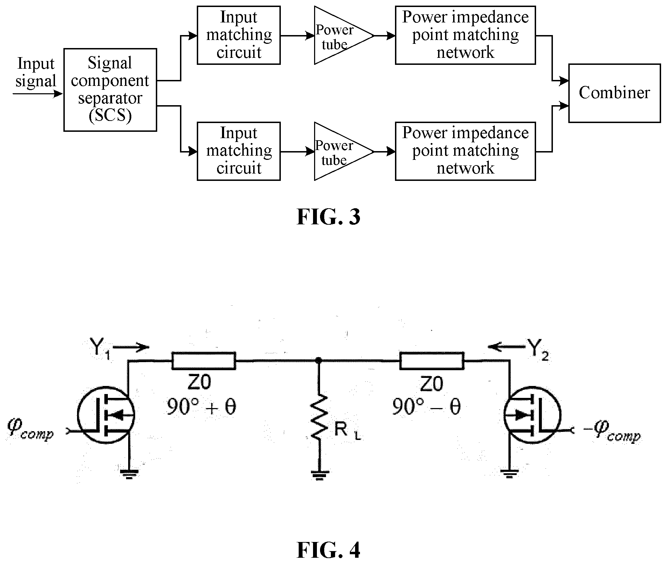

FIG. 3 is a schematic diagram showing composition of an outphasing power amplifier according to the present application. As shown in FIG. 3, the outphasing power amplifier includes a signal component separator, two or more power amplifier branches and a combiner, where each power amplifier branch of the two or more power amplifier branches includes an input matching circuit, an power tube and an output matching circuit.

The signal component separator is configured to separate a signal source into two outphasing constant envelope signals and output the two outphasing constant envelope signals to two input matching circuits respectively.

The input matching circuit is configured to achieve matching between an output impedance of a signal source and an input impedance of the power tube.

The power tube is configured to amplify a received signal.

The output matching circuit is configured to match an optimal impedance corresponding to peak output power of the power tube and an optimal impedance corresponding to average output power of the power tube to two input terminals of the combiner, respectively.

The combiner is configured to combine output power of two power amplifiers into one signal and output the one signal.

In the outphasing power amplifier provided in the present application, since the impedance matched to the combiner satisfies an impedance value required for load modulation, the output power of the outphasing power amplifier is ensured to be maximum, and the high-efficiency operation of the power amplifier is achieved. In addition, since the outphasing power amplifier of the present application does not need to process a harmonic amplitude of a second, third or even higher and phase of a fundamental wave, a design complexity is reduced, for example, a circuit design complexity is simplified, a PCB occupied area is reduced, and a debugging difficulty is also reduced.

In an embodiment, the combiner may be a Chireix non-isolated combiner with two inputs terminals connected to two power tube output matching circuits respectively, and an output terminal of the Chireix non-isolated combiner is connected to a 50 ohm terminal load.

In an embodiment, the combiner may also be a low impedance Chireix non-isolated combiner.

In an embodiment, the each power amplifier branch includes at least one of a first harmonic tuning circuit and a second harmonic tuning circuit, where the first harmonic tuning circuit is connected between the output matching circuit and the power tube; and the second harmonic tuning circuit is connected between the output matching circuit and the combiner. The harmonic tuning circuit is used to further improve the power amplifier efficiency.

In an embodiment, the output matching circuit is configured as below.

A compensation angle of the combiner is calculated according to a signal output power back-off (OPBO) of a signal source, that is, a signal peak-to-average ratio.

A ratio of the optimal impedance $Z_{m1}$ corresponding to the peak output power of the power tube to the optimal impedance $Z_{m2}$ corresponding to the average output power of the power tube is determined according to the compensation angle obtained from calculation, where the ratio is a standing wave ratio.

A maximum power point impedance Zopt of the power tube is determined by using a load pull mode according to a size of an equal standing wave ratio circle obtained from the standing wave ratio. A back-off high efficiency point impedance Zbk_eff is searched on the equal standing wave ratio circle by using the maximum power point impedance Zopt as a reference point.

An impedance value corresponding to the maximum power point impedance Zopt and an impedance value corresponding to the back-off high efficiency point impedance Zbk_eff are matched to the two input terminals of the combiner, respectively.

In an embodiment, the compensation angle $\varphi_{comp}$ of the combiner may be calculated according to formula (1):

$$\varphi_{comp} = \arccos\left(10^{\frac{-OPBO}{20}}\right) \tag{1}$$

In an embodiment, the step of determining the standing wave ratio includes steps described below. Since the Chireix non-isolated combiner may be implemented by a microstrip circuit through an appropriate impedance such as Z0 in formula (3) and an electrical length such as θ in formula (2), a circuit schematic diagram and circuit parameters are shown in FIG. 4. In FIG. 4:

$$\theta = \arcsin\left(\sqrt{\frac{R_L}{2Z_{in}}}\sin(2\varphi_{comp})\right) \tag{2}$$

$$Z0 = \frac{\sqrt{2Z_{in}R_L}}{\cos\theta} \tag{3}$$

In formula (2) and formula (3), the signal peak-to-average ratio is corresponded to a microstrip impedance electrical length of the Chireix non-isolated combiner through the compensation angle $\varphi_{comp}$, and generally Zin is 50 ohms (Ω), $R_L$ is 25Ω, and the corresponding Chireix non-isolated combiner is 50Ω.

Admittance Y, conductance G and susceptance B of an input port of the Chireix non-isolated combiner may be obtained according to the following formula:

$$Y_1 = G'_o - j(B'_o - B'_{comp}) = \frac{2\cos^2\phi}{R_L} - j\frac{\sin 2\phi - \sin 2\varphi_{comp}}{R_L} \qquad (4)$$

$$Y_2 = G'_o + j(B'_o - B'_{comp}) = \frac{2\cos^2\phi}{R_L} + j\frac{\sin 2\phi - \sin 2\varphi_{comp}}{R_L} = Y_1^* \qquad (5)$$

$$\text{where} \quad B'_{comp} = \frac{\sin 2\varphi_{comp}}{R_L}$$

From formula (4) and formula (5), it could be seen that during an input outphasing angle φ changes, a load impedance faced by two PA branches of the Chireix non-isolated combiner is always changing, and loads of the two PA branches are the same at two points of the compensation angle $\varphi_{Comp}$ and a 45° mirror image about the compensation angle $\varphi_{comp}$, and are both real numbers. The impedance faced by the two PA branches is different at the rest of the time. Two impedance crossing points of the two PA branches are a crossing point m1 and a crossing point m2, and impedances of the crossing point m1 and the crossing point m2 are determined by the compensation angle $\varphi_{comp}$. Assuming that admittance Y1 of an input port 1 and admittance Y2 of an input port 2 obtained according to formula (4) and formula (5) are equal, a relationship between the impedances of the crossing point m1 and the crossing point m2 (that is, the impedance $Z_{m1}$ of the crossing point m1 and the impedance $Z_{m2}$ of the crossing point m2) can be obtained and is shown in formula (6):

$$Z_{m1}/Z_{m2} = Y_2/Y_1 = \frac{1}{\tan^2 \varphi_{comp}} \qquad (6)$$

In order to ensure the system efficiency, in the present application, the impedance $Z_{m1}$ of the crossing point m1 corresponds to the maximum power point impedance Zopt, and the impedance $Z_{m2}$ of the crossing point m2 corresponds to the power back-off point impedance Zbk_eff.

In the outphasing power amplifier of the present application, load impedances only at the two points of the two PA branches are equal. Therefore, the two points are taken as a boundary condition of a design in the present application, and only when both the crossing point m1 and the crossing point m2 are satisfied to be high efficiency at the same time, the outphasing power amplifier can be ensured to achieve the high efficiency. Formula (6) determines a standing wave ratio of a terminal load, and thereby also determines that a standing wave ratio corresponding to the maximum power point impedance Zopt and the power back-off point impedance Zbk_eff is also $\dfrac{1}{\tan^2 \varphi_{comp}}$ .

The applicant of the present application considers that the PA needs to maintain a state of high efficiency throughout an impedance change process. In practical application, according to probability density function (PDF) distribution of the signal, PA can be guaranteed to have a high average efficiency only by ensuring a high instantaneous efficiency between the maximum power point and the back-off power point. Therefore, according to the size of the equal standing wave ratio circle of formula (6), the maximum power point impedance Zopt of the power tube is found in the load pull mode, and then the back-off high efficiency point impedance Zbk_eff is searched, that is, found on the equal standing wave ratio circle by using the maximum power point impedance Zopt as the reference point. Then the maximum power point impedance Zopt and the back-off high efficiency point impedance Zbk_eff are matched as corresponding impedance values to the crossing point m1 and the crossing point m2, respectively, as corresponding impedance values. At this time, a transfer function H(s) of the output matching circuit should satisfy requirements of formula (7) and formula (8) simultaneously.

$$H(s) = Zm1/Zopt(s) \qquad (7)$$

$$H(s) = Zm2/Zbk\_eff(s) \qquad (8)$$

In formula (7) and formula (8), Zopt(s) and Zbk_eff(s) represent characteristic functions of Zopt and Zbk_eff, where the characteristic functions vary with frequency, respectively. In practical application, H(s) may be implemented by a microstrip circuit, and generally $Z_{m1}$ is a system impedance such as 50Ω.

The present application further provides a computer-readable storage medium, which is configured to store computer-executable instructions for implementing the method for achieving output matching described in any one of the embodiments.

In an embodiment not covered by the appended claims, the present application further provides a device for achieving output matching of a power amplifier, and the device includes a determination module and a matching module.

The determination module is configured to determine a maximum power point impedance Zopt and a back-off high efficiency point impedance Zbk_eff according to a signal peak-to-average ratio of a signal source of a power tube.

The matching module is configured to match the determined maximum power point impedance Zopt and the determined back-off high efficiency point impedance Zbk_eff to two input terminals of a combiner.

The determination module is configured to: determine a compensation angle of the combiner according to the signal peak-to-average ratio of the signal source from the power tube; determine a ratio of an optimal impedance Zm1 corresponding to peak output power of the power tube to an optimal impedance Zm2 corresponding to average output power of the power tube according to the compensation angle, where the ratio is a standing wave ratio; determine the maximum power point impedance Zopt of the power tube, by using a load pull mode, according to a size of an equal standing wave ratio circle obtained from the standing wave ratio; and search the back-off high efficiency point impedance Zbk_eff on the equal standing wave ratio circle by using the maximum power point impedance Zopt as a reference point.

In another embodiment not covered by the appended claims, the present application further provides a power amplifier branch including an input matching circuit, a power tube and an output matching circuit.

The input matching circuit is configured to achieve matching between an output impedance of a signal source and an input impedance of the power tube.

The power tube is configured to amplify a received signal.

The output matching circuit is configured to match an optimal impedance corresponding to peak output power of the power tube and an optimal impedance corresponding to average output power of the power tube to two input terminals of the combiner respectively.

In an embodiment, the output matching circuit is configured as below.

A compensation angle of the combiner is determined according to a signal peak-to-average ratio of a signal source from the power tube.

A ratio of the optimal impedance Zm1 corresponding to the peak output power of the power tube to the optimal impedance Zm2 corresponding to the average output power of the power tube is determined according to the determined compensation angle, where the ratio is a standing wave ratio.

A maximum power point impedance Zopt of the power tube is determined by using a load pull mode according to a size of an equal standing wave ratio circle obtained from the standing wave ratio. A back-off high efficiency point impedance Zbk_eff is found on the equal standing wave ratio circle by using the maximum power point impedance Zopt as a reference point.

An impedance value corresponding to the maximum power point impedance Zopt and an impedance value corresponding to the back-off high efficiency point impedance Zbk_eff are matched to the two input terminals of the combiner respectively.

The present application further provides an apparatus for achieving output matching including a processor and a memory. The memory stores computer-executable instructions that can be run on the processor, when executed by the processor, the computer-executable instructions implement the following operations: determining a maximum power point impedance Zopt and a back-off high efficiency point impedance Zbk_eff according to a signal peak-to-average ratio of a signal source of a power tube; and matching the determined maximum power point impedance Zopt and the back-off high efficiency point impedance Zbk_eff to two input terminals of a combiner respectively.

The present application further provides a flowchart of a method for achieving output matching of an outphasing power amplifier, and the flowchart includes steps 1 to 4.

In step 1, a compensation angle of a combiner is calculated according to a signal output power back-off (OPBO) of a signal source, that is, a signal peak-to-average ratio.

Implementation of this step may refer to formula (1).

In step 2, a ratio of an optimal impedance $Z_{m1}$ corresponding to peak output power of a power tube to an optimal impedance $Z_{m2}$ corresponding to average output power of the power tube is determined according to the compensation angle obtained from calculation, where the ratio is a standing wave ratio.

The standing wave ratio in this step may refer to formula (6).

In order to ensure the system efficiency, in the present application, an impedance $Z_{m1}$ of a crossing point m1 corresponds to a maximum power point impedance Zopt, and an impedance $Z_{m2}$ of a crossing point m2 corresponds to a power back-off point impedance Zbk_eff.

In the outphasing power amplifier of the present application, load impedances only at two points of two PA branches are equal. Therefore, the two points are taken as a boundary condition of a design in the present application, only when both the crossing point m1 and the crossing point m2 are satisfied to be high efficiency at the same time, the outphasing power amplifier can be ensured to achieve high efficiency. Formula (6) determines a standing wave ratio of a terminal load, and thereby also determines that the standing wave ratio corresponding to the maximum power point impedance Zopt and the power back-off point impedance Zbk_eff is also $\dfrac{1}{\tan^2 \varphi_{comp}}$.

The crossing point m1 and the crossing point m2 are two impedance crossing points of the two PA branches of the outphasing power amplifier of the present application shown in FIG. 3, and impedances of the crossing point m1 and the crossing point m2 are determined by the compensation angle $\varphi_{comp}$.

In step 3, the maximum power point impedance Zopt of the power tube is determined by using a load pull mode according to a size of an equal standing wave ratio circle. A back-off high efficiency point impedance Zbk_eff is found on the equal standing wave ratio circle by using the maximum power point impedance Zopt as a reference point.

The applicant of the present application considers that the PA needs to maintain a state of high efficiency throughout an impedance change process. In practical application, according to probability density function (PDF) distribution of the signal, PA can be guaranteed to have a high average efficiency only by ensuring a high instantaneous efficiency between the maximum power point and the back-off power point. Therefore, according to the size of the equal standing wave ratio circle of formula (6), the maximum power point impedance Zopt of the power tube is found in the load pull mode, and then the back-off high efficiency point impedance Zbk_eff is found on the equal standing wave ratio circle by using the maximum power point impedance Zopt as the reference point. Then the maximum power point impedance Zopt and the back-off high efficiency point impedance Zbk_eff are matched as corresponding impedance values to the crossing point m1 and the crossing point m2, respectively, as corresponding impedance values. At this time, a transfer function H(s) of the output matching circuit should satisfy requirements of formula (7) and formula (8) simultaneously.

In step 4, the maximum power point impedance Zopt and the back-off high efficiency point impedance Zbk_eff are matched to the two input terminals of the combiner respectively as corresponding impedance values.

In the method for achieving output matching of the outphasing power amplifier provided in the present application, since the impedance matched to the combiner satisfies an impedance value required for load modulation, output power of the outphasing power amplifier is ensured to be maximum, and the high-efficiency operation of the power amplifier is achieved. In addition, since the outphasing power amplifier of the present application does not need to process a harmonic amplitude of a second, third or even higher and phase of a fundamental wave, a design complexity is reduced, for example, a circuit design complexity is simplified, a PCB occupied area is reduced, and a debugging difficulty is also reduced.

The technical solution of the present application will be described in detail below in conjunction with the application embodiments.

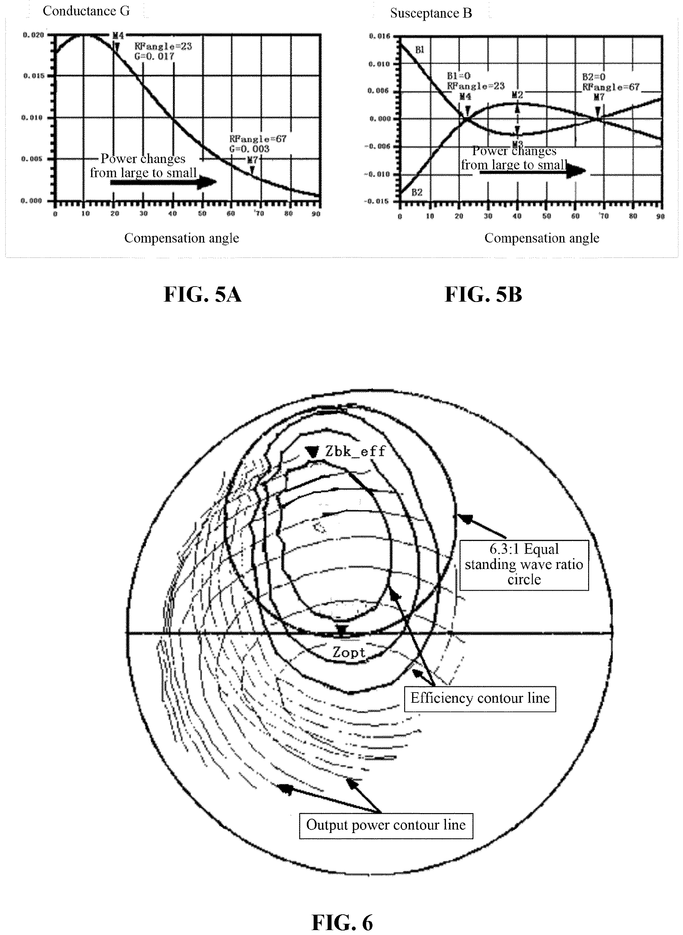

A signal source of about 7dB in a long term evolution (LTE) system is described as an example, and a compensation angle corresponding to a peak-to-average ratio of a signal source is about 23°. As shown in FIG. 5A and FIG. 5B, corresponding conductance G and susceptance B may be obtained from the above-mentioned formula.

In this embodiment, when the compensation angle is selected as 23°, corresponding load impedance susceptances are compensated to 0 at 23° and 67° respectively, that is, loads of the PA with the compensation angle of 23° and 67° are in a pure real resistance state, and a standing wave ratio relation between a crossing point M4 and a crossing point M7 is 5.66 and may be obtained from using formula (6). As shown in FIG. 5A and FIG. 5B, during the outphasing angle changing from 0° to 90°, output power indicated by arrows in FIG. 5A and FIG. 5B changes from large to small, and the load impedance of the PA tends to gradually increase. The PA in this embodiment maintains a state of high efficiency throughout an entire impedance change process. However, in view of the practical application, according to PDF distribution of the signal, PA can be guaranteed to have a high average efficiency only by ensuring a high instantaneous efficiency between the maximum power point and the back-off power point. Therefore, according to the size of the equal standing wave ratio circle of formula (6), as shown in FIG. 6, the maximum power point impedance Zopt of the power tube is found in the load pull mode, and the back-off high efficiency point impedance Zbk_eff is found on the equal standing wave ratio circle by using the maximum power point impedance Zopt as the reference point. Finally, the output matching circuit in FIG. 3 matches the maximum power point impedance Zopt and the back-off high efficiency point impedance Zbk_eff to the crossing point M4 and the crossing point M7 in FIG. 5B, respectively, as corresponding impedance values.

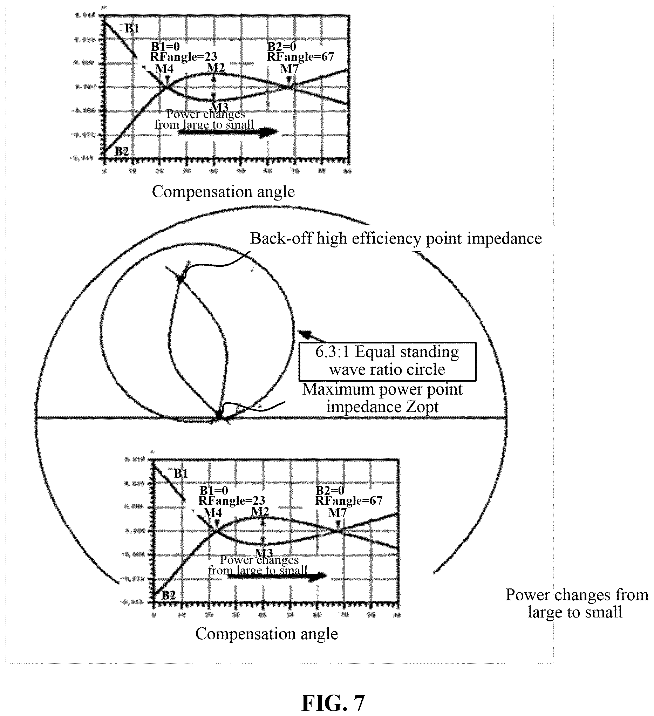

FIG. 7 is a schematic diagram of an embodiment in which an output matching circuit achieves matching according to the present application. As shown in FIG. 7, a power tube with a model of CREE CGH40045 is described as an example, assuming that a signal peak-to-average ratio is 7dB, and it could be obtained from the above analysis that theoretically the standing wave ratio corresponding to the maximum power point impedance and the back-off high efficiency point impedance of the power tube is 5.66. However, in view of non-ideality of a component in actual implementation, a value of the standing wave ratio may be appropriately increased, such as by about 10% in order to ensure an impedance variation range. In this way, an actual impedance conversion ratio, that is, the standing wave ratio is 6.3.

For convenience of measurement, assuming that a terminating load impedance ZL corresponding to the maximum power point is 50Ω in this embodiment, then a load impedance ZL' corresponding to the back-off high efficiency point is 315Ω according to formula (6). 50Ω is matched to the maximum power point of the power tube and 315Ω is matched to the back-off high efficiency point, and a relevant impedance relationship is shown in Table 1.

Table 1

| Frequency (MHz) | ZL=50Ω | | ZL'=315Ω | |
|---|---|---|---|---|
| | Terminating load impedance corresponding to a maximum power point | | Load impedance corresponding to a back-off high efficiency point | |
| 2140 | 3.969-j0.142 | Maximum power point impedance Zopt | 1.255+j3.710 | Back-off power point impedance Zbk_eff |
| | Output power (Pout) (dBm) | 47.9 | Pout (dBm) | 41 |
| | Efficiency (Eff) (%) | 80.9 | Eff (%) | 86.9 |

Next, as shown in FIG. 6, first, according to a power contour line and an efficiency contour line, an impedance point that satisfies target saturation power and has relatively high efficiency is selected as the maximum power point impedance Zopt; then, by using the maximum power point impedance Zopt as the reference point, a point with back-off power reaching a target 7dB and having higher efficiency is found on a circle with the standing wave ratio of 6.3 and taken as the back-off high efficiency point impedance Zbk_eff; and finally, the maximum power point impedance Zopt and the back-off high efficiency point impedance Zbk_eff are matched to 50Ω and 315Ω respectively by using an advance design system (ADS) and other related circuit simulation tools through the output matching circuit.

As can be seen from the method for achieving the output matching network provided in the present application, when the power amplifier load changes in a standing wave ratio range of 1: 6.3, the power amplifier still maintains a relatively high efficiency.

In an embodiment, the combiner in the present application may also be a low impedance Chireix non-isolated combiner, such as a low impedance Chireix non-isolated combiner with a characteristic impedance of 7.93Ω. In this case, an impedance correspondence of the power impedance point output matching circuit is shown in Table 2.

Table 2

| Frequency (MHz) | ZL=7.93Ω | | ZL=50Ω | |
|---|---|---|---|---|
| | Max power delivered | | Back off power | |
| 2140 | 3.969-j0.142 | Zopt | 1.255+j3.710 | Zbk_eff |
| | Pout (dBm) | 47.9 | Pout (dBm) | 41 |
| | Eff (%) | 80.9 | Eff (%) | 86.9 |

In an embodiment not covered by the appended claims, the present application may further be used in a multi-path outphasing system, and as shown in FIG. 9, FIG. 9 shows a composition architecture of a 4-path outphasing power amplifier.

In an embodiment, FIG. 8 is a schematic diagram showing composition of an outphasing power amplifier of another embodiment according to the present application. As shown in FIG. 8 in this embodiment, harmonic tuning circuits are added in the power impedance point matching network, that is, before and after the output matching circuit to further improve the power amplifier efficiency.

An embodiment of the present application further provides a computer-readable storage medium, which is configured to store computer-executable instructions for implementing the method for achieving output matching described in any one of the embodiments.

An embodiment of the present application further provides an apparatus for achieving media transmission, including a processor and a memory. The memory stores computer programs that can be run on the processor, and the computer programs are configured to: calculate a compensation angle of a combiner according to a signal OPBO of a signal source, that is, a signal peak-to-average ratio; determine a ratio of an optimal impedance $Z_{m1}$ corresponding to peak output power of a power tube to an optimal impedance $Z_{m2}$ corresponding to average output power of the power tube according to the determined compensation angle, where the ratio is a standing wave ratio; determine a maximum power point impedance Zopt of the power tube, by using a load pull mode, according to a size of an equal standing wave ratio circle; find a back-off high efficiency point impedance Zbk_eff on the equal standing wave ratio circle by using the maximum power point impedance Zopt as a reference point; and match the maximum power point impedance Zopt and the back-off high efficiency point impedance Zbk_eff to two input terminals of the combiner respectively as corresponding impedances.

**Claims**

1. An outphasing power amplifier, comprising: a signal component separator, two power amplifier branches and a Chireix non-isolated combiner;

   wherein each power amplifier branch of the two power amplifier branches comprises an input matching circuit, a power transistor and an output matching circuit; wherein the signal component separator is configured to separate an input signal of the outphasing power amplifier into two outphasing constant envelope signals and output the two outphasing constant envelope signals to two input matching circuits in the two power amplifier branches, respectively;
   wherein for each power amplifier branch:

   the input matching circuit is configured to achieve matching between an output impedance of a respective output terminal of the signal component separator and an input impedance of the power transistor;
   the power transistor is configured to amplify an outphasing constant envelope signal outputted from the signal component separator through the input matching circuit, and the amplified outphasing constant envelope signal is inputted to the output matching circuit; and
   the output matching circuit is configured to match an optimal impedance Zm1 corresponding to a peak output power of the power transistor and an optimal impedance Zm2 corresponding to an average output power of the power transistor to a respective input terminal of the Chireix non-isolated combiner;
   wherein the Chireix non-isolated combiner is configured to receive from the output matching circuits the output signals of the power transistors and combine them into one signal and output the one signal;
   **characterized in that**, in order to determine the values of the optimal impedances Zm1 and Zm2, the output matching circuit is configured to:

   determine a compensation angle of the Chireix non-isolated combiner according to an output power back-off level of the power transistor, wherein the compensation angle $\varphi_{comp}$ of the Chireix non-isolated combiner is calculated according to the following formula:

   $$\varphi_{comp} = \arccos\left(10^{\frac{-OPBO}{20}}\right),$$

   wherein the OPBO denotes the output power back-off level of the power transistor;
   determine a ratio of the optimal impedance Zm1 corresponding to the peak output power of the power transistor to the optimal impedance Zm2 corresponding to the average output power of the power transistor according to the determined compensation angle, wherein the ratio is a standing wave ratio, and the ratio is calculated according to the following formula:

   $$Zm1/Zm2 \qquad = \frac{1}{tan^2\,\phi comp};$$

   determine a maximum power point impedance Zopt of the power transistor, by using a load pull mode, according to a size of an equal standing wave ratio circle obtained from the standing wave ratio; and
   search a back-off high efficiency point impedance Zbk_eff on the equal standing wave ratio circle by using the maximum power point impedance Zopt as a reference point;
   wherein the optimal impedance Zm1 equals to the maximum power point impedance Zopt, and the optimal impedance Zm2 equals to the back-off high efficiency point impedance Zbk_eff.

2. The outphasing power amplifier of claim 1, wherein each power amplifier branch comprises at least one of a first harmonic tuning circuit or a second harmonic tuning circuit; wherein

   the first harmonic tuning circuit is connected between the output matching circuit and the power transistor; and
   the second harmonic tuning circuit is connected between the output matching circuit and the Chireix non-isolated combiner.

3. The outphasing power amplifier of claim 1 or 2, wherein the Chireix non-isolated combiner is a low impedance Chireix non-isolated combiner.

4. A method for achieving output matching of an outphasing power amplifier, wherein the outphasing power amplifier comprises a signal component separator, two power amplifier branches and a Chireix non-isolated combiner, each power amplifier branch of the two power amplifier branches comprises an input matching circuit, a power transistor and an output matching circuit, wherein the method comprises for the output matching circuit of each power amplifier branch:

   determining a maximum power point impedance Zopt and a back-off high efficiency point impedance Zbk_eff according to an output power back-off level of the power transistor; and
   matching distribution of the determined maximum power point impedance Zopt and distribution of the determined back-off high efficiency point impedance Zbk_eff to a respective input terminal of the Chireix non-isolated combiner;
   **characterized in that**, the determining the maximum power point impedance Zopt and the back-off high efficiency point impedance Zbk_eff according to the output power back-off level of the power transistor comprises:

   determining a compensation angle of the Chireix non-isolated combiner according to the output power back-off level of the power transistor, wherein the compensation angle $\varphi_{comp}$ of the Chireix non-isolated combiner is calculated according to the following formula:

   $$\varphi_{comp} = \arccos\left(10^{\frac{-OPBO}{20}}\right),$$

   wherein the *OPBO* denotes the output power back-off level of the power transistor; determining a ratio of an optimal impedance Zm1 corresponding to peak output power of the power transistor to an optimal impedance Zm2 corresponding to average output power of the power transistor according to the compensation angle, wherein the ratio is a standing wave ratio, and the ratio is calculated according to the following formula:

   $$Zm1/Zm2 \qquad = \frac{1}{\tan^2 \phi comp};$$

   determining the maximum power point impedance Zopt of the power transistor, by using a load pull mode, according to a size of an equal standing wave ratio circle obtained from the standing wave ratio; and
   searching the back-off high efficiency point impedance Zbk_eff on the equal standing wave ratio circle by using the maximum power point impedance Zopt as a reference point; wherein the optimal impedance Zm1 equals to the maximum power point impedance Zopt, and the optimal impedance Zm2 equals to the back-off high efficiency point impedance Zbk_eff.

5. A computer-readable storage medium, which is configured to store computer-executable instructions which, when executed by a computer, cause the computer to implement the method for achieving output matching of claim 4.

6. An apparatus for achieving output matching, **characterized by** comprising: a processor and a memory; wherein the memory stores computer-executable instructions that can be run on the processor, when executed by the processor, the computer-executable instructions implement the method for achieving output matching of claim 4.

**Patentansprüche**

1. Phasenverschobener Leistungsverstärker, umfassend: einen Signalkomponententrenner, zwei Leistungsverstärkerzweige und einen nicht isolierten Chireix-Kombinator;

   wobei jeder Leistungsverstärkerzweig der zwei Leistungsverstärkerzweige eine Eingangsanpassungsschaltung, einen Leistungstransistor und eine Ausgangsanpassungsschaltung umfasst; wobei der Signalkomponententrenner konfiguriert ist, um ein Eingangssignal des phasenverschobenen Leistungsverstärkers in zwei phasenverschobene konstante Hüllkurvensignale zu trennen und die zwei phasenverschobene konstante Hüllkurvensignale an zwei Eingangsanpassungsschaltungen in den zwei Leistungsverstärkerzweigen jeweils auszugeben;
   wobei für jeden Leistungsverstärkerzweig:

   die Eingangsanpassungsschaltung konfiguriert ist, um eine Anpassung zwischen einer Ausgangsimpedanz eines jeweiligen Ausgangsanschlusses des Signalkomponententrenners und einer Eingangsimpedanz des Leistungstransistors zu realisieren;
   der Leistungstransistor konfiguriert ist, um ein phasenverschobenes konstantes Hüllkurvensignal, das von dem Signalkomponententrenner durch die Eingangsanpassungsschaltung ausgegeben wird, zu verstärken, und das verstärkte phasenverschobene konstante Hüllkurvensignal in die Ausgangsanpassungsschaltung eingegeben wird; und
   die Ausgangsanpassungsschaltung konfiguriert ist, um eine optimale Impedanz Zm1, die einer Spitzenausgangsleistung des Leistungstransistors entspricht, und eine optimale Impedanz Zm2, die einer durchschnittlichen Ausgangsleistung des Leistungstransistors entspricht, an einen jeweiligen Eingangsanschluss des nicht isolierten Chireix-Kombinators anzupassen;
   wobei der nicht isolierte Chireix-Kombinator konfiguriert ist, um von den Ausgangsanpassungsschaltungen die Ausgangssignale der Leistungstransistoren zu empfangen und sie zu einem Signal zu kombinieren und das eine Signal auszugeben;
   **dadurch gekennzeichnet, dass**, um die Werte der optimalen Impedanzen Zm1 und Zm2 zu bestimmen, die Ausgangsanpassungsschaltung konfiguriert ist, zum:

   Bestimmen eines Kompensationswinkels des nicht isolierten Chireix-Kombinators gemäß einem Ausgangsleistungs-Backoff-Pegel des Leistungstransistors, wobei der Kompensationswinkel $\varphi_{Komp}$ des nicht isolierten Chireix-Kombinators gemäß der folgenden Formel berechnet wird:

   $$\varphi_{Komp} = \arccos(10^{\frac{-OPBO}{20}}),$$

   wobei OPBO den Ausgangsleistungs-Backoff-Pegel des Leistungstransistors bezeichnet;
   Bestimmen eines Verhältnisses der optimalen Impedanz Zm1, die der Spitzenausgangsleistung des Leistungstransistors entspricht, zu der optimalen Impedanz Zm2, die der durchschnittlichen Ausgangsleistung des Leistungstransistors entspricht, gemäß dem bestimmten Kompensationswinkel, wobei das Verhältnis ein Stehwellenverhältnis ist, und das Verhältnis sich nach folgender Formel errechnet:

   $$Zm1 / Zm2 = \frac{1}{tan^2 \phi Komp};$$

   Bestimmen einer maximalen Leistungspunktimpedanz Zopt des Leistungstransistors unter Verwendung eines Lastzugmodus gemäß einer Größe eines aus dem Stehwellenverhältnis erhaltenen Kreises mit gleichem Stehwellenverhältnis; und
   Suchen nach einer Backoff-Hocheffizienzpunktimpedanz Zbk_eff auf dem Kreis mit gleichem Stehwellenverhältnis unter Verwendung der maximalen Leistungspunktimpedanz Zopt als Referenzpunkt; wobei die optimale Impedanz Zm1 gleich der maximalen Leistungspunktimpedanz Zopt ist und die optimale Impedanz Zm2 gleich der Backoff-Hocheffizienzpunktimpedanz Zbk_eff ist.

2. Phasenverschobener Leistungsverstärker nach Anspruch 1, wobei jeder Leistungsverstärkerzweig mindestens einen von einer harmonischen Abstimmschaltung oder einer zweiten harmonischen Abstimmschaltung umfasst; wobei

die erste harmonische Abstimmschaltung zwischen die Ausgangsanpassungsschaltung und den Leistungstransistor geschaltet ist; und
die zweit harmonische Abstimmschaltung zwischen die Ausgangsanpassungsschaltung und den nicht isolierten Chireix-Kombinator geschaltet ist.

3. Phasenverschobener Leistungsverstärker nach Anspruch 1 oder 2, wobei der nicht isolierte Chireix-Kombinator ein nicht isolierter Chireix-Kombinator mit niedriger Impedanz ist.

4. Verfahren zur Realisierung einer Ausgangsanpassung eines Phasenverschobener Leistungsverstärkers, wobei der Phasenverschobener Leistungsverstärker einen Signalkomponententrenner, zwei Leistungsverstärkerzweige und einen nicht isolierten Chireix-Kombinator umfasst, wobei jeder Leistungsverstärkerzweig der zwei Leistungsverstärkerzweige eine Eingangsanpassungsschaltung, einen Leistungstransistor und eine Ausgangsanpassungsschaltung umfasst, wobei das Verfahren für die Ausgangsanpassungsschaltung jedes Leistungsverstärkerzweigs umfasst:

Bestimmen einer maximalen Leistungspunktimpedanz Zopt und einer Backoff-Hocheffizienzpunktimpedanz Zbk_eff gemäß einem Ausgangsleistungs-Backoff-Pegel des Leistungstransistors; und
Anpassen der Verteilung der bestimmten maximalen Leistungspunktimpedanz Zopt und der Verteilung der bestimmten Backoff-Hocheffizienzpunktimpedanz Zbk_eff an einen entsprechenden Eingangsanschluss des nicht isolierten Chireix-Kombinators;
**dadurch gekennzeichnet, dass** das Bestimmen der maximalen Leistungspunktimpedanz Zopt und der Back-off-Hocheffizienzpunktimpedanz Zbk_eff gemäß dem Ausgangsleistungs-Backoff-Pegel des Leistungstransistors umfasst:

Bestimmen eines Kompensationswinkels des nicht isolierten Chireix-Kombinators gemäß dem Ausgangsleistungs-Backoff-Pegel des Leistungstransistors, wobei der Kompensationswinkel $\varphi_{Komp}$ des nicht isolier-ten Chireix-Kombinators gemäß der folgenden Formel berechnet wird:

$$\varphi_{Komp} = \arccos(10^{\frac{-OPBO}{20}}),$$

wobei *OPBO* den Ausgangsleistungs-Backoff-Pegel des Leistungstransistors bezeichnet; Bestimmen eines Verhältnisses einer optimalen Impedanz Zm1, die der Spitzenausgangsleistung des Leistungstransistors entspricht, zu einer optimalen Impedanz Zm2, die der durchschnittlichen Ausgangsleistung des Leistungstransistors entspricht, gemäß dem Kompensationswinkel, wobei das Verhältnis ein Stehwellenverhältnis ist, und das Verhältnis sich nach folgender Formel errechnet:

$$Zm1\,/Zm2 = \frac{1}{tan^2\phi Komp};$$

Bestimmen der maximalen Leistungspunktimpedanz Zopt des Leistungstransistors unter Verwendung eines Lastzugmodus gemäß einer Größe eines aus dem Stehwellenverhältnis erhaltenen Kreises mit gleichem Stehwellenverhältnis; und
Suchen nach der Backoff-Hocheffizienzpunktimpedanz Zbk_eff auf dem Kreis mit gleichem Stehwellenverhältnis unter Verwendung der maximalen Leistungspunktimpedanz Zopt als Referenzpunkt; wobei die optimale Impedanz Zm1 gleich der maximalen Leistungspunktimpedanz Zopt ist und die optimale Impedanz Zm2 gleich der Backoff-Hocheffizienzpunktimpedanz Zbk_eff ist.

5. Computerlesbares Speichermedium, das so konfiguriert ist, dass es computerausführbare Anweisungen speichert, die, wenn sie von einem Computer ausgeführt werden, bewirken, dass der Computer das Verfahren zur Realisierung einer Ausgabeanpassung nach Anspruch 4 implementiert.

6. Gerät zur Realisierung einer Ausgangsanpassung, **dadurch gekennzeichnet, dass** es umfasst: einen Prozessor und einen Speicher; wobei der Speicher computerausführbare Anweisungen speichert, die auf dem Prozessor ausgeführt werden können, wobei die computerausführbaren Anweisungen, wenn sie von dem Prozessor ausgeführt werden, das Verfahren zur Realisierung einer Ausgabeanpassung nach Anspruch 4 implementieren.

**Revendications**

1. Amplificateur de puissance de déphasage, comprenant : un séparateur de composantes de signal, deux branches d'amplificateur de puissance et un combineur non isolé Chireix ; dans lequel chaque branche d'amplificateur de puissance des deux branches d'amplificateur de puissance comprend un circuit d'adaptation d'entrée, un transistor de puissance et un circuit d'adaptation de sortie ; dans lequel le séparateur de composantes de signal est configuré pour séparer un signal d'entrée de l'amplificateur de puissance de déphasage en deux signaux d'enveloppe constante de déphasage et émettre les deux signaux d'enveloppe constante de déphasage vers deux circuits d'adaptation d'entrée dans les deux branches d'amplificateur de puissance, respectivement ;

   dans lequel pour chaque branche d'amplificateur de puissance :

   le circuit d'adaptation d'entrée est configuré pour obtenir une adaptation entre une impédance de sortie d'une borne de sortie respective du séparateur de composantes de signal et une impédance d'entrée du transistor de puissance ;
   le transistor de puissance est configuré pour amplifier un signal d'enveloppe constante de déphasage émis par le séparateur de composantes de signal via le circuit d'adaptation d'entrée, et le signal d'enveloppe constante de déphasage amplifié est entré dans le circuit d'adaptation de sortie ; et
   le circuit d'adaptation de sortie est configuré pour adapter une impédance optimale Zm1 correspondant à une puissance de sortie de crête du transistor de puissance et une impédance optimale Zm2 correspondant à une puissance de sortie moyenne du transistor de puissance à une borne d'entrée respective du combineur non isolé Chireix ;
   dans lequel le combineur non isolé Chireix est configuré pour recevoir des circuits d'adaptation de sortie les signaux de sortie des transistors de puissance et les combiner en un signal et émettre le signal ;
   **caractérisé en ce que**, pour déterminer les valeurs des impédances optimales Zm1 et Zm2, le circuit d'adaptation de sortie est configuré pour :

   déterminer un angle de compensation du combineur non isolé Chireix en fonction d'un niveau de réduction de puissance de sortie du transistor de puissance, dans lequel l'angle de compensation $\varphi_{comp}$ du combineur non isolé Chireix est calculé selon la formule suivante :

   $$\varphi_{comp} = \arccos(10^{\frac{-OPBO}{20}}),$$

   dans lequel OPBO désigne le niveau de réduction de puissance de sortie du transistor de puissance ;
   déterminer un rapport de l'impédance optimale Zm1 correspondant à la puissance de sortie de crête du transistor de puissance à l'impédance optimale Zm2 correspondant à la puissance de sortie moyenne du transistor de puissance selon l'angle de compensation déterminé, dans lequel le rapport est un rapport d'onde stationnaire, et le rapport est calculé selon la formule suivante :

   $$Zm1 / Zm2 = \frac{1}{tan^2 \phi comp};$$

   déterminer une impédance de point de puissance maximale Zopt du transistor de puissance, à l'aide d'un mode de traction de charge, selon une taille d'un cercle de rapport d'onde stationnaire égal obtenu à partir du rapport d'onde stationnaire ; et
   rechercher une impédance de point à haut rendement de réduction Zbk_eff sur le cercle de rapport d'onde stationnaire égal à l'aide de l'impédance de point de puissance maximale Zopt comme point de référence ;
   dans lequel l'impédance optimale Zm1 est égale à l'impédance de point de puissance maximale Zopt, et l'impédance optimale Zm2 est égale à l'impédance de point à haut rendement de réduction Zbk_eff.

2. Amplificateur de puissance de déphasage selon la revendication 1, dans lequel chaque branche d'amplificateur de puissance comprend au moins l'un parmi un circuit d'accord de première harmonique ou un circuit d'accord de seconde harmonique ; dans lequel

   le circuit d'accord de première harmonique est connecté entre le circuit d'adaptation de sortie et le transistor de puissance ; et

le circuit d'accord de seconde harmonique est connecté entre le circuit d'adaptation de sortie et le combineur non isolé Chireix.

3. Amplificateur de puissance de déphasage selon la revendication 1 ou 2, dans lequel le combineur non isolé Chireix est un combineur non isolé Chireix à faible impédance.

4. Procédé pour obtenir une adaptation de sortie d'un amplificateur de puissance de déphasage, dans lequel l'amplificateur de puissance de déphasage comprend un séparateur de composantes de signal, deux branches d'amplificateur de puissance et un combineur non isolé Chireix, chaque branche d'amplificateur de puissance des deux branches d'amplificateur de puissance comprend un circuit d'adaptation d'entrée, un transistor de puissance et un circuit d'adaptation de sortie, dans lequel le procédé comprend pour le circuit d'adaptation de sortie de chaque branche d'amplificateur de puissance :

la détermination d'une impédance de point de puissance maximale Zopt et d'une impédance de point à haut rendement de réduction Zbk_eff selon un niveau de réduction de puissance de sortie du transistor de puissance ; et
l'adaptation de la distribution de l'impédance de point de puissance maximale déterminée Zopt et de la distribution de l'impédance de point à haut rendement de réduction déterminée Zbk_eff à une borne d'entrée respective du combineur non isolé Chireix ;
**caractérisé en ce que** la détermination de l'impédance de point de puissance maximale Zopt et de l'impédance de point à haut rendement de réduction Zbk_eff selon le niveau de réduction de puissance de sortie du transistor de puissance comprend :

la détermination d'un angle de compensation du combineur non isolé Chireix selon le niveau de réduction de puissance de sortie du transistor de puissance, dans lequel l'angle de compensation $\varphi_{comp}$ du combineur non isolé Chireix est calculé selon la formule suivante :

$$\varphi_{comp} = \arccos(10^{\frac{-OPBO}{20}}),$$

dans lequel *OPBO* désigne le niveau de réduction de puissance de sortie du transistor de puissance ; la détermination d'un rapport de l'impédance optimale Zm1 correspondant à la puissance de sortie de crête du transistor de puissance à l'impédance optimale Zm2 correspondant à la puissance de sortie moyenne du transistor de puissance selon l'angle de compensation, dans lequel le rapport est un rapport d'onde stationnaire, et le rapport est calculé selon la formule suivante :

$$Zm1/Zm2 = \frac{1}{tan^2\phi comp};$$

la détermination d'une impédance de point de puissance maximale Zopt du transistor de puissance, à l'aide d'un mode de traction de charge, selon une taille d'un cercle de rapport d'onde stationnaire égal obtenu à partir du rapport d'onde stationnaire ; et
la recherche de l'impédance de point à haut rendement de réduction Zbk_eff sur le cercle de rapport d'onde stationnaire égal à l'aide de l'impédance de point de puissance maximale Zopt comme point de référence ; dans lequel l'impédance optimale Zm1 est égale à l'impédance de point de puissance maximale Zopt, et l'impédance optimale Zm2 est égale à l'impédance de point à haut rendement de réduction Zbk_eff.

5. Support de stockage lisible par ordinateur, qui est configuré pour stocker des instructions exécutables par ordinateur qui, lorsqu'elles sont exécutées par un ordinateur, amènent l'ordinateur à mettre en œuvre le procédé permettant d'obtenir une adaptation de sortie selon la revendication 4.

6. Appareil pour obtenir une adaptation de sortie, **caractérisé en ce qu'**il comprend : un processeur et une mémoire ; dans lequel la mémoire stocke des instructions exécutables par ordinateur qui peuvent être exécutées sur le processeur, lorsqu'elles sont exécutées par le processeur, les instructions exécutables par ordinateur mettent en œuvre le procédé pour obtenir une adaptation de sortie selon la revendication 4.

**FIG. 1**

**FIG. 2**

```
Input          Signal                  Input                    Power impedance
signal   →   component    →         matching   →  Power  →     point matching   ┐
             separator               circuit       tube           network       │
               (SCS)                                                            ├→ Combiner
                           →         Input                    Power impedance   │
                                    matching   →  Power  →     point matching   ┘
                                     circuit       tube           network
```

**FIG. 3**

**FIG. 4**

FIG. 5A          FIG. 5B

FIG. 6

FIG. 7

**FIG. 8**

**FIG. 9**

**REFERENCES CITED IN THE DESCRIPTION**

**Patent documents cited in the description**

- EP 2838195 A1

**Non-patent literature cited in the description**

- A Package-Integrated Chireix Outphasing RF Switch-Mode High-Power Amplifier. **CALVILLO-CORTES DAVID et al.** IEEE TRANSACTIONS ON MICROWAVE THEORY AND TECHNIQUES. PLENUM, 01 October 2013, vol. 61, 3721-3732

- A Generalized Combiner Synthesis Technique for Class-E Outphasing Transmitters. **OZEN MUSTAFA et al.** IEEE TRANSACTIONS ON CIRCUITS AND SYSTEM I: REGULAR PAPERS. IEEE, 01 May 2017, vol. 64, 1126-1139
- **BARTON TAYLOR et al.** Not Just a Phase: Outphasing Power Amplifiers. *IEEE MICROWAVE MAGAZINE, IEEESERVICE CENTER, PISCATAWAY, NJ, US,* 01 February 2016, vol. 17 (2), 18-31